**Europäisches Patentamt**

**European Patent Office**

**Office européen des brevets**

(19)

(11) Veröffentlichungsnummer : **0 067 364**
**B1**

(12) **EUROPÄISCHE PATENTSCHRIFT**

(45) Veröffentlichungstag der Patentschrift :
11.11.87

(21) Anmeldenummer : 82104834.5

(22) Anmeldetag : 02.06.82

(51) Int. Cl.⁴ : **H 03 K 21/18**, H 03 K 21/08,
**H 03 K 21/40**

(54) Verfahren und Anordnung zum nichtflüchtigen Speichern des Zählerstandes einer elektronischen Zählschaltung.

(30) Priorität : 12.06.81 DE 3123444

(43) Veröffentlichungstag der Anmeldung :
22.12.82 Patentblatt 82/51

(45) Bekanntmachung des Hinweises auf die Patenterteilung : 11.11.87 Patentblatt 87/46

(84) Benannte Vertragsstaaten :
AT DE FR GB IT

(56) Entgegenhaltungen :
EP-A- 0 026 980
FR-A- 2 408 118
FR-A- 2 421 493
GB-A- 1 322 869
US-A- 3 820 073
INSTITUTE OF ELECTRICAL AND ELECTRONICS
ENGINEERS, International Symposium on Fault-Tolerant Computing, 21.-23. Juni 1976, Seiten 138-147,
New Jersey, USA F.J. O'BRIEN: "Rollback point
insertion strategies"
IBM TECHNICAL DISCLOSURE BULLETIN, Band 20,
Nr. 5, Oktober 1977, Seiten 1955-1958, New York, USA
N.K. OUCHI et al.: "Check point copy for a two-stage
store"

(73) Patentinhaber : Siemens Aktiengesellschaft Berlin
und München
Wittelsbacherplatz 2
D-8000 München 2 (DE)

(72) Erfinder : Schrenk, Hartmut, Dr. Dipl.-Phys.
Fasanenweg 22
D-8013 Haar (DE)

## Beschreibung

Die Erfindung betrifft ein Verfahren und eine Anordnung zum nichtflüchtigen Speichern des Zählerstandes einer elektronischen Zählschaltung, bei dem der jeweilige Zählerstand durch elektrisches Umprogrammieren eines nichtflüchtigen Datenspeichers abgespeichert wird.

Im Bereich der Zähltechnik werden insbesondere in der Kraftfahrzeugtechnik z. B. als Kilometerzähler in der Regel mechanische Zählwerke verwendet, bei denen das Festhalten bzw. Abspeichern des jeweiligen Zählerstandes unproblematisch ist. Darüberhinaus ist aus der GB-A-1 322 869 eine elektronische Zählschaltung bekannt, bei der der Zählerstand durch elektrisches Umprogrammieren eines nichtflüchtigen Datenspeichers abgespeichert wird. Mit der Entwicklung nichtflüchtiger, elektrisch umprogrammierbarer Speicher (EEPROM's) ist es möglich geworden, wie bei den bekannten Random Access Speichern (RAM's) die gespeicherte Information einerseits zu ändern, die geänderte Information andererseits aber, ähnlich wie in den bekannten Read Only Memories (ROM's), auch ohne Betriebsspannung zu speichern. EEPROM's vereinigen also die positiven Eigenschaften beider Speichertypen und können deshalb grundsätzlich überall da eingesetzt werden, wo die sich ändernden Daten auch nach Abschalten der Betriebsspannung gesichert werden müssen. Insbesondere eignen sie sich in diesem Zusammenhang zur Speicherung des Zählerstandes einer elektronischen Zählschaltung.

EEPROM-Speicher benötigen aber eine Umprogrammierzeit, die bei handelsüblichen EEPROM-Speichern zwischen 1 ms und 1 s liegt. Diese Eigenschaft steht bei unvorhergesehenem Abschalten der Betriebsspannung, z. B. in einem Störungsfall, der zuverlässigen Datensicherung entgegen, da während der Umprogrammierzeit die abgespeicherte Information undefiniert ist. Wird während des Umprogrammierens die Betriebsspannung z. B. in einem Störungsfall abgeschaltet, so kann im angewählten Speicherbereich sowohl die alte als auch die neue Information verloren sein.

Dieses Risiko kann dadurch verringert werden, daß man den EPROM-Speicher gemeinsam mit den notwendigen Ansteuerschaltungen mit einem getrennten Stromkreis betreibt, der aus einer eigenen Batterie oder einem geeigneten Speicherkondensator gespeist wird, und die nichtflüchtige Speicherung von der extern zugeführten Spannung weitgehend unabhängig macht. Als Nachteile bleiben aber nicht nur ein erhöhtes Restrisiko für die Zuverlässigkeit der Datensicherung, insbesondere nach mehreren kurzzeitigen und dicht aufeinanderfolgenden Einbrüchen der Versorgungsspannung, sondern auch der Aufwand für den eigenen, die Beendigung eines Programmiervorgangs nach Abschalten der externen Betriebsspannung ermöglichenden Versorgungskreis.

Aus der EP-A 0 026 980 ist ein Verfahren bekannt, bei dem Teile eines nicht-flüchtigen Speichers, sogenannte « pages » in einen flüchtigen Speicher ausgelesen werden, dort verändert werden und anschließend wieder in den nicht-flüchtigen Speicher eingeschrieben werden. Dieses Verfahren unterscheidet sich jedoch in wesentlichen Punkten sowohl vom gattungsgemäßen Verfahren als auch vom erfindungsgemäßen Verfahren : Während das Verfahren nach EP-A 0 026 980 u. a. einen flüchtigen Speicher verwendet, werden sowohl das gattungsgemäße Verfahren als auch das erfindungsgemäße Verfahren auf den Zählerstand einer elektronischen Zählschaltung angewandt. Die Zählschaltung kann naturgemäß nur (numerische) Zählwerte als Zählerstand aufweisen, wohingegen der flüchtige Speicher der EP-A 0 026 980 beliebige Werte, insbesondere Datenverarbeitungsprogramme speichern kann. Nach Spannungsausfall muß zur Wiederherstellung der Daten der gesamte Speicher nach einem « verbotenen Muster » durchsucht werden.

Aufgabe der vorliegenden Erfindung ist es, hier Abhilfe zu schaffen und ein Verfahren zum nichtflüchtigen Speichern des Zählerstandes einer elektronischen Zählschaltung vorzusehen, das auch bei Betriebsspannungseinbrüchen eine sichere Speicherung des Zählerstandes ermöglicht, ohne daß ein zusätzlicher Stromkreis benötigt wird.

Diese Aufgabe wird bei einem Verfahren der eingangs genannten Art dadurch gelöst, daß die jeweils neuen Zählerstandsdaten vor dem Löschen der alten Zählerstandsdaten in einen anderen Adreßbereich des Datenspeichers eingeschrieben werden und daß zwischen den zur Umprogrammierung des Datenspeichers notwendigen Einzelschritten Speicherzellen eines nichtflüchtigen Steuerspeichers seschrieben oder gelöscht werden, aus deren logischen Zuständen Steuerinformationen zur Beendigung eines unterbrochenen Umprogrammiervorgangs ableitbar sind.

Da die Informationsänderung im Datenspeicher, in dem der jeweilige Zählerstand nichtflüchtig registriert ist, in der Weise vorgenommen wird, daß man zunächst den neuen Zählerstand abspeichert, bevor man die alten Zählinformationen löscht, bleibt bei einer Betriebsspannungsunterbrechung während des Abspeicherns des neuen Zählerstandes zumindest die korrekte Zählerinformation erhalten.

Unsicherheiten darüber, welche von mehreren im Datenspeicher aufgefundenen Informationen nach einem gestörten Speichervorgang gültig sind, werden vermieden, da bei Änderung des Zählerstandes zwischen den einzelnen Schritten des Umprogrammierens (Einschreiben der neuen Information, Löschen der alten Information) zusätzlich ein Steuerspeicher programmiert und gelöscht wird. Bei Unterbrechung des Umprogrammiervorgangs kann nach dem Wiedereinschalten der Betriebsspannung aus den logischen Zuständen einer oder mehrerer Zellen des Steuerspeichers beispielsweise mit Hilfe einer Dekodierschaltung auf eindeutige Weise festgelegt werden, welcher Adreßbereich des Datenspeichers eine gültige Information enthält, bzw. wie eine gültige Information aus der noch nicht gelöschten

2

vorhergehenden Information rekonstruiert werden kann und wie der unterbrochene Umprogrammiervorgang nachträglich beendet werden kann. Das Umprogrammieren des Datenspeichers kann somit ohne Informationsverlust in einem beliebigen Zustand abgebrochen werden.

Es liegt im Rahmen der Erfindung, daß Steuerinformationen zur Beendigung eines unterbrochenen Umprogrammiervorgangs durch logische oder arithmetische Verknüpfung der im Datenspeicher gespeicherten Daten gewonnen werden.

Um eine Erhöhung der Zählrate zu ermöglichen, ist es von Vorteil, daß der Umprogrammiervorgang nur bei jeder n-ten Änderung des Zählerstandes durchgeführt wird.

Eine Anordnung zur Durchführung des erfindungsgemäßen Verfahrens wird vorteilhafterweise so ausgeführt, daß eine Zählschaltung vorgesehen ist, die über eine Ablaufsteuerung mit wenigstens einem elektrisch umprogrammierbaren, nichtflüchtigen Datenspeicher verbunden ist und daß ein mit der Ablaufsteuerung verbundener nichtflüchtiger Steuerspeicher vorgesehen ist, dessen Speicherzellen in Abhängigkeit von zum Umprogrammieren des Datenspeichers notwendigen Einzelschritten beschreibbar oder löschbar sind.

Vorteilhafterweise weist der Datenspeicher mindestens zwei Adreßbereiche auf, in die die Zählerstandsdaten abwechselnd einschreibbar sind.

Es liegt im Rahmen der Erfindung, daß eine erste Speicherzelle des Steuerspeichers vorgesehen ist, aus deren logischen Zustand ableitbar ist, in welchem Adreßbereich des Datenspeichers der gültige Zählerstand gespeichert ist, daß eine zweite Speicherzelle des Steuerspeichers vorgesehen ist, aus deren logischen Zustand ableitbar ist, ob ein den ersten Adreßbereich des Datenspeichers betreffender Schreibvorgang unterbrochen wurde, daß mindestens eine weitere Speicherzelle des Steuerspeichers vorgesehen ist, aus deren logischen Zustand ableitbar ist, ob ein einen weiteren Adreßbereich des Datenspeichers betreffender Schreibvorgang unterbrochen wurde und daß eine Löschspeicherzelle des Steuerspeichers vorgesehen ist, aus derem logischen Zustand ableitbar ist, ob nach erfolgtem Schreibvorgang der Löschvorgang unterbrochen wurde.

Um die Anzahl der benötigten Bauelemente gering zu halten, ist es vorteilhaft, einen elektrisch umprogrammierbaren, nichtflüchtigen Speicher vorzusehen, dessen Speicherzellen in Bereiche für den Datenspeicher und in Bereiche für den Steuerspeicher unterteilt sind.

Da bei jedem Einbruch der Versorgungsspannung grundsätzlich die Möglichkeit der Veränderung der gerade bearbeiteten Daten besteht, wird der Abbruch des Umprogrammierablaufs vorteilhafterweise über an die Ablaufsteuerung ein Abbruchsignal liefernden Spannungssensor veranlaßt. Der Spannungssensor kann auch beim Wiedereinschalten der Betriebsspannung das Startsignal für alle erforderlichen Operationen liefern.

In der Datenverarbeitungsliteratur (z. B. A. Osborne, Einführung in die Mikrocomputertechnik, 1977, te-wi Verlag, München) wird das Markieren bzw. die Beeinflussung eines Programmablaufs über den logischen Zustand speziell zugeordneter Register auch als das Setzen oder Rücksetzen von « Flags » bezeichnet. Erfindungsgemäß sind diese Flagregister, die während des Umprogrammierens des Datenspeichers im Steuerspeicher gesetzt oder zurückgesetzt werden, nicht flüchtig. Die Speicherzellen des Steuerspeichers werden nachfolgend daher als Flagregister oder Flags bezeichnet.

Die Erfindung wird im folgenden anhand der Figuren näher erläutert. Die Zeichnung 1 zeigt das Blockschaltbild eines Ausführungsbeispiels zur Durchführung des erfindungsgemäßen Verfahrens.

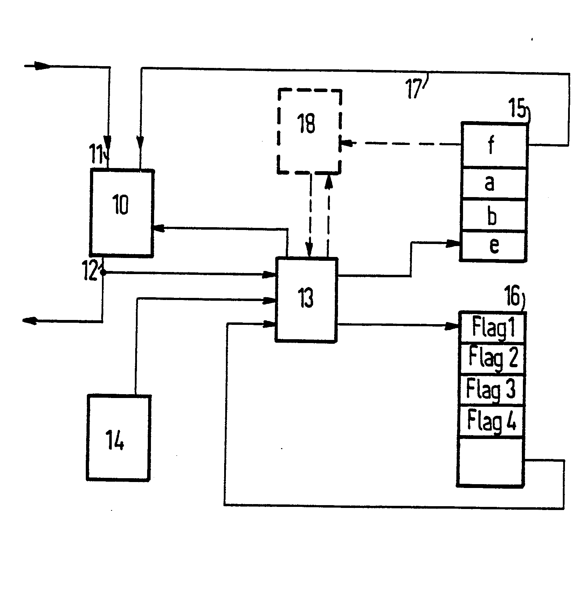

Die in der Fig. 1 gezeigte Zählschaltung 10, z. B. ein haldelsüblicher Zähler, übernimmt das Zählen der am Zähleingang 11 anliegenden einzelnen Ereignisse. Über ihren Ausgang 12 kann, gegebenenfalls unter Verwendung einer geeigneten Umkodierschaltung, der Zählerstand z. B. an einem Display angezeigt werden. Über die Ablaufsteuerung 13 wird der dem Ausgang 12 der Zählschaltung 10 entnehmbare Zählerstand dem Datenspeicher 15 zugeführt. Der zur Aufnahme der Zählerinformation dienende Datenspeicher 15 ist ein handelsüblicher, elektrisch programmier -und löschbarer Festwertspeicher (EEPROM), wie er beispielsweise aus W. Söll und J.-H. Kirchner, « Digitale Datenspeicher », 1978, Vogel-Verlag, Würzburg, Seiten 160 bis 163 bekannt ist, der mit Steuereingängen zur Kontrolle des Umprogrammierablaufs versehen ist. Er weist zwei Adreßbereiche a bzw. b auf, in denen abwechselnd in geeigneter Kodierung der letzte Stand der Zählschaltung 10 abgespeichert bzw. der vorhergehende Zählerstand gelöscht wird. Der von der Ablaufsteuerung 13 beaufschlagte Steuerspeicher 16 kann ebenfalls als handelsübliches EEPROM ausgeführt sein. Es ist aber auch möglich, den Steuerspeicher 16 in einem getrennten Adreßbereich f des Datenspeichers 15 anzuordnen. Für jede Flagmarkierung ist wenigstens eine Speicherzelle, d. h. ein Datenbit, erforderlich.

Die die Ablaufsteuerung 13 beaufschlagende Sensorschaltung 14 erkennt einen Einbruch der Versorgungsspannung und liefert ein geeignetes Abbruchsignal an die Ablaufsteuerung 13. Die Sensorschaltung 14 kann auch so ausgeführt sein, daß sie bei Spannungsspitzen der Versorgungsschaltung (« Spikes ») ein Abbruchsignal liefert. Beim Einschalten der erfindungsgemäßen Anordnung gibt die Sensorschaltung 14 ferner ein Startsignal für die Abfrage des Steuerspeichers 16 ab. Sie kann entsprechend der bei Mikrocomputern üblichen Reset-Schaltungen (wie z. B. in U. Tietze und CH. Schenk, « Halbleiter-Schaltungstechnik », Springer-Verlag, Berlin, Heidelberg, New York, 1980, Seiten 558, 559 beschrieben) ausgeführt sein.

Die Ablaufsteuerung 13 ermittelt aus den an ihren Eingängen anliegenden Signalen von Zählschaltung 10, Sensorschaltung 14 und Steuerspeicher 16 die erforderlichen Ausgangssignale, die erfindungs-

# 0 067 364

gemäß zur Steuerung des Programmierablaufs benötigt werden. Sie kann in an sich bekannter Weise z. B. als programmierbares logisches Feld (PLA, beispielsweise beschrieben in U. Tietze und CH. Schenk. Seiten 177 bis 179) ausgeführt sein. Es ist auch möglich, die Funktionen der Ablaufsteuerung 13 softwaremäßig mit einem handelsüblichen Mikroprozessor zu realisieren.

Bei Verwendung eines entsprechenden Mikroprozessors kann die gesamte erfindungsgemäße Anordnung mit einem Mikroprozessor und einem elektrisch umprogrammierbaren nichtflüchtigen Speicher realisiert werden. Es ist aber auch möglich, die erforderlichen Schaltungsteile in einem oder mehreren anwendungsspezifischen Schaltkreisen zu integrieren.

Der Ablauf der Umprogrammierung des Datenspeichers 15 wird mittels der Tabelle 1 verdeutlicht. Die Tabelle 1 zeigt den Ablauf der Umprogrammierung des Datenspeichers 15 in einer erfindungsgemäßen Zählanordnung, in welcher der Zustand des Datenspeichers 15 während des Umprogrammierens durch vier Flagregister (Flag 1, Flag 2, Flag 3 und Flag 4), d. h. vier nichtflüchtige Flag-Speicherzellen im Steuerspeicher 16 markiert wird. Im dargestellten speziellen Fall dient das Flag 1 zur Kennzeichnung einer gültigen Adresse. Ist das Datenbit des Flag 1 « O » (« low »), so ist der gültige Zählerstand im Adreßbereich a des Datenspeichers 15 gespeichert, ist das Datenbitdes Flags 1 gleich 1, so ist der gültige Zählerstand im Adreßbereich b des Datenspeichers 15 gespeichert.

Zur Kennzeichnung eines Schreibzustandes im Adreßbereich b dient das Flag 2, während das Flag 3 zur Kennzeichnung eines Schreibzustandes im Adreßbereich a dient. Wird im Adreßbereich b des Datenspeichers 15 ein Schreibvorgang eingeleitet und durchgeführt, so ist Flag 2 gleich 1. Flag 2 gleich 0 zeigt, daß ein Schreibvorgang im Adreßbereich b beendet ist. Für Flag 3 und den Adreßbereich a gilt Entsprechendes.

Zur Kennzeichnung eines Löschvorgangs innerhalb des Adreßbereichs a oder des Adreßbereichs b wird das Flag 4 in der Weise verwendet, daß bei Vorliegen eines Löschvorgangs in einem der Adressenbereiche a oder b Flag 4 gleich 1 und anderweitig gleich 0 ist.

Die einzelnen Schritte Nummer 1 bis 7 des Umprogrammiervorgangs sind in der ersten Spalte der Tabelle 1 zusammengestellt.

Im Adreßbereich a bzw. b liegen, abwechselnd eingeschrieben, die jeweiligen alten und neuen Informationen über den Zählerstand der Zählschaltung 10. Bei regulärem Ablauf, d. h. ohne Betriebsspannungsunterbrechung, kann nach jeder Änderung des Zählerstandes der richtige Wert aus dem Adreßbereich a oder b des Datenspeichers 15, festgelegt durch Flag 1, ausgelesen werden. Der Flagzustand 0000 im Steuerspeicher 16 (Flag 1 = 0, Flag 2 = 0, Flag 3 = 0, Flag 4 = 0) bedeutet also, daß der gültige Zählerstand im Adreßbereich a gespeichert ist, während der Adreßbereich b gelöscht ist. Die erfindungsgemäße Anordnung befindet sich in Zählbereitschaft (Schritt 1), ein ankommender Zählimpuls kann fehlerfrei verarbeitet werden. Ist aber während des Auslesens aus dem Steuerspeicher 16 eines der drei Flagregister Flag 2, Flag 3 oder Flag 4 gesetzt, d. h. im logischen « 1 »-Zustand, so ist erkennbar, daß der Programmiervorgang nicht regulär bis zum Ende durchgeführt wurde.

Ein Flagzustand 0100 im Steuerspeicher 16 gemäß Schritt 2 (Schreibanforderung für Adreßbereich b) oder Schritt 3 (neuer Zählerstand in Adreßbereich b speichern) bedeutet nach dem Wiedereinschalten der Zählschaltung nach einem Betriebsspannungseinbruch, daß ein Schreibvorgang im Adreßbereich b unterbrochen wurde, entsprechend dem Flagstand 1010 im Falle des Adreßbereiches a. In diesem Falle (Flagstand 0100) wird die Ablaufsteuerung 13, gegebenenfalls über eine zwischen dem Ausgang des Steuerspeichers 16 und dem Eingang der Ablaufsteuerung 13 geschaltete Flagdekodierschaltung, die aus dem logischen Zustand der Flagregister die notwendigen Steuersignale für den Ablauf des Umprogrammiervorgangs ermittelt, so gesteuert, daß vom Adreßbereich a der noch ungelöschte alte Zählerstand anstelle des im Adreßbereich b befindlichen Zählerstandes ausgelesen wird. Mit diesem alten Zählerstand wird die, z. B. als Vorwahlzähler ausgeführte Zählschaltung 10 über die vom Datenspeicher 15 kommende Datenleitung 17 gesetzt. Nach dem über die Ablaufsteuerung 13 veranlaßten Hinzufügen eines Zählimpulses enthält die Zählschaltung 10 sodann den korrekten Zählerstand. Der Umprogrammiervorgang kann damit nach dem Wiedereinschalten der Betriebsspannung entsprechend der Tabelle 1 wiederholt und richtig abgeschlossen werden.

Wird entsprechend den Schritten 4 (Schreibendequittung für Adreßbereich b, Flag 4 setzen) und 4a (Wechsel des gültigen Adreßbereichs, Flag 1 ändern) gleichzeitig ein Schreibflag (Flag 2 bzw. Flag 3) und ein Löschflag (Flag 4) als gesetzt registriert, so kann der Adressenbereich der gültigen Zählinformation nicht aus dem Flag 1 entnommen werden, da nicht bekannt ist, ob Flag 1 bereits umgeschaltet hat. Der zutreffende Adreßbereich wird vielmehr durch den Zustand der Flags 2 bzw. 3 angezeigt, so daß der Flagdekoder in beiden Fällen erkennt, daß im Adreßbereich b bzw. a des Datenspeichers 15 ein neuer Zählerstand korrekt eingeschrieben ist, der Programmierablauf jedoch nicht ordnungsgemäß zu Ende geführt wurde. Das gleiche gilt, wenn nur das Löschflag (Flag 4) beim Wiedereinschalten der Betriebsspannung gesetzt war. Die fehlenden Schritte werden, nachdem sie erkannt sind, über die Ablaufsteuerung 13 nachgeholt.

Die Flagzustände im Steuerspeicher 16 für die Schritte 5 (Löschanforderung Adreßbereich a, Flag 2 zurücksetzen), 6 (Löschen alte Information im Adreßbereich a) und 7 (Löschendenquittung, Flag 4 rücksetzen) sind ebenfalls der Tabelle 1 zu entnehmen. In der unteren Hälfte der Tabelle 1 ist der entsprechende Ablauf der Umprogrammierung des Datenspeichers 15 für die Umprogrammierung vom Adreßbereich b in den Adreßbereich a dargestellt.

4

Unabhängig davon, bei welchem der Schritte während der Umprogrammierung der Programmiervorgang durch einen Spannungseinbruch unterbrochen wurde, wird nach dem erfindungsgemäßen Verfahren für die Zählerschaltung 10 nach dem Wiedereinschalten der Betriebsspannung der richtige Zählerstand ermittelt. Einzige mögliche Fehlerquelle bildet die unmittelbar nach dem Eintreffen eines Zählimpulses bis zum Setzen eines Schreibflags (Flag 2, Flag 3) bestehende Totzeit. Dieser Fehler betrifft jedoch maximal einen einzigen Zählimpuls.

Bei Verwendung der beschriebenen vier Flags ist eine vom Datenspeicher 15 beaufschlagte, in der Fig. 1 gestrichelt dargestellte Auswertelogik 18, die ausgangsseitig die Ablaufsteuerung 13 beaufschlagt, nicht notwendig. In einer geänderten Ausführungsform der erfindungsgemäßen Zählschaltung kann aber beispielsweise die gültige Adreßinformation anstatt aus dem Flag 1 auch aus den im Datenspeicher 15 enthaltende Informationen mit Hilfe der Auswertelogik 18 zurückgewonnen werden. Beim Auslesen werden dann die Informationen der beiden Adreßbereiche a und b herangezogen. Durch logische Operationen mit dem Inhalt der beiden Adreßbereiche a und b ist z. B. feststellbar, ob der Inhalt eines Adreßbereiches a oder b des Datenspeichers 15 gleich oder ungleich 0 ist und ob der Inhalt eines Adreßbereichs größer als der Inhalt des zweiten Adreßbereichs ist. Der gültige Adreßbereich wird z. B. daran erkannt, daß sein Inhalt größer als 0 ist (anderer Adreßbereich bereits gelöscht) oder daß der Inhalt im gültigen Adreßbereich größer als der Inhalt im anderen Adreßbereich (alter Zählerstand) ist. Fehler können ausnahmsweise bei einem Zählerüberlauf mit korrekter Auslesung 0 auftreten.

Ein Umprogrammieren des Datenspeichers 15 abwechselnd mit dem Steuerspeicher 16 verlängert im Vergleich zum minimalen Speichervorgang die gesamte Umprogrammierdauer. In den Fällen, in denen die Zählrate kritisch ist, kann dieser Nachteil dadurch vermindert werden, daß der Umprogrammiervorgang nur bei jeder n-ten Änderung des Zählerstandes durchgeführt wird. Löst beispielsweise nur jeder zehnte oder jeder hundertste Zählimpuls den angegebenen erfindungsgemäßen Umprogrammiervorgang mit Setzen der Flags aus, so können die dazwischenliegenden Impulse z. B. einzeln in einem getrennten Adreßbereich e des Datenspeichers 15 registriert werden. Beim Auslesen ergibt sich der korrekte Zählerstand dann erst als Summe der beiden Teilspeicher a und e bzw. b und e. Neben einer Verkürzung der mittleren Umprogrammierzeit resultiert auf diese Weise auch eine geringere Umprogrammierhäufigkeit jeder einzelnen Speicherzelle des Datenspeichers 15. Damit wird gleichzeitig das Problem der begrenzten Anzahl zulässiger Umprogrammiervorgänge aller zur Zeit handelsüblichen EEPROM's verringert.

Vorteilhafterweise wird eine entsprechende « Einzel »-Abspeicherung mit einem speziellen 1 aus n-Code in der Weise verwendet, daß mit jedem neuen Zählimpuls nur ein weiteres Bit zusätzlich in die eine, feste Speicheradresse (Adreßbereich e) eingeschrieben wird :

z. B. Zählerstand z :                       Erfindungsgemäß speichern mit Flagsetzen.
    Zählerstand z + 1 :                Einzelspeicherung 000 000 001
    Zählerstand z + 2 :                Einzelspeicherung 000 000 011
    Zählerstand z + 3 :                Einzelspeicherung 000 000 111
usw.

Zwischen den Einzelimpulsen wird also nicht gelöscht, so daß keine Information verfälscht werden kann. Der korrekte Zählerstand ergibt sich also immer durch Abzählen der Einsen und Hinzuaddieren dieses Wertes zum Stand von Adreßbereich a oder b. Wegen des mit der « Einzel »-Abspeicherung verbundenen Speicherplatzbedarfs wird n vorteilhaft zwischen 10 und 100 gewählt.

Da also bei Unterbrechung oder Störung des Umprogrammiervorgangs nach dem Wiedereinschalten der erfindungsgemäßen Zählanordnung ein nichtflüchtiger Steuerspeicher 16 verwendet wird, kann aus den logischen Zuständen einer oder mehrerer Zellen des Steuerspeichers 16 eindeutig rekonstruiert werden, welcher Adreßbereich des Datenspeichers 15 eine gültige Information enthält bzw. wie eine gültige Information aus der noch nicht gelöschten vorausgehenden Information gewonnen wird und wie der unterbrochene Umprogrammiervorgang nachträglich beendet werden kann. Das Umprogrammieren des Datenspeichers kann somit ohne Informationsverlust zu einem beliebigen Zeitpunkt abgebrochen und zu einem späteren Zeitpunkt beendet werden.

## Patentansprüche

1. Verfahren zum nichtflüchtigen Speichern des Zählerstandes einer elektronischen Zählschaltung, bei dem der jeweilige Zählerstand durch elektrisches Umprogrammieren eines nichtflüchtigen Datenspeichers (15) abgespeichert wird, dadurch gekennzeichnet, daß die jeweils neuen Zählerstandsdaten vor dem Löschen der alten Zählerstandsdaten in einen anderen Adreßbereich des Datenspeichers (15) eingeschrieben werden und daß zwischen den zur Umprogrammierung des Datenspeichers (15) notwendigen Einzelschritten Speicherzellen eines nichtflüchtigen Steuerspeichers (16) beschrieben oder gelöscht werden, aus deren logischen Zuständen Steuerinformationen zur Beendigung eines unterbrochenen Umprogrammiervorgangs ableitbar sind.

2. Verfahren nach Anspruch 1, dadurch gekennzeichnet, daß die Steuerinformationen zur Beendi-

**0 067 364**

gung eines unterbrochenen Umprogrammiervorgangs durch logische oder arithmetische Verknüpfung der im Datenspeicher (15) gespeicherten Daten gewonnen werden.

3. Verfahren nach Anspruch 1 oder 2, dadurch gekennzeichnet, daß der Umprogrammiervorgang nur bei jeder n-ten Änderung des Zählerstandes durchgeführt wird.

4. Anordnung zur Durchführung des Verfahrens nach einem der Ansprüche 1 bis 3, dadurch gekennzeichnet, daß eine Zählschaltung (10) vorgesehen ist, die über eine Ablaufsteuerung (13) mit wenigstens einem elektrisch umprogrammierbaren, nichtflüchtigen Datenspeicher (15) verbunden ist und daß ein mit der Ablaufsteuerung (13) verbundener nichtflüchtiger Steuerspeicher (16) vorgesehen ist, dessen Speicherzellen (Flag 1, Flag 2, Flag 3, Flag 4) in Abhängigkeit von zum Umprogrammieren des Datenspeichers (15) notwendigen Einzelschritten beschrieben oder gelöscht werden.

5. Anordnung nach Anspruch 4, dadurch gekennzeichnet, daß der Datenspeicher (15) mindestens zwei Adreßbereiche (a, b) aufweist, in die Zählerstandsdaten abwechselnd einschreibbar sind.

6. Anordnung nach Anspruch 4 oder 5, dadurch gekennzeichnet, daß eine erste Speicherzelle (Flag 1) des Steuerspeichers (16) vorgesehen ist, aus deren logischen Zustand ableitbar ist, in welchem Adreßbereich (a, b) des Datenspeichers (15) der gültige Zählerstand gespeichert ist.

7. Anordnung nach einem der Ansprüche 4 bis 6, dadurch gekennzeichnet, daß eine zweite Speicherzelle (Flag 2) des Steuerspeichers (16) vorgesehen ist, aus deren logischem Zustand ableitbar ist, ob ein den ersten Adreßbereich (a) des Datenspeichers (15) betreffender Schreibvorgang unterbrochen wurde.

8. Anordnung nach einem der Ansprüche 4 bis 7, dadurch gekennzeichnet, daß mindestens eine weitere Speicherzelle (Flag 3) des Steuerspeichers (16) vorgesehen ist, aus deren logischem Zustand ableitbar ist, ob ein einen weiteren Adreßbereich (b) des Datenspeichers (15) betreffender Schreibvorgang unterbrochen wurde.

9. Anordnung nach einem der Ansprüche 4 bis 8, dadurch gekennzeichnet, daß eine Löschspeicherzelle (Flag 4) des Steuerspeichers (16) vorgesehen ist, aus derem logischem Zustand ableitbar ist, ob nach erfolgtem Schreibvorgang der Löschvorgang unterbrochen wurde.

10. Anordnung nach einem der Ansprüche 4 bis 9, dadurch gekennzeichnet, daß ein elektrisch umprogrammierbarer, nichtflüchtiger Speicher vorgesehen ist, dessen Speicherzellen in Bereiche für den Datenspeicher (15) und in Bereiche für den Steuerspeicher (16) unterteilt sind.

11. Anordnung nach einem der Ansprüche 4 bis 10, dadurch gekennzeichnet, daß eine im Falle eines Einbruchs der Versorgungsspannung ein Abbruchsignal an die Ablaufsteuerung (13) liefernde Sensor- schaltung (14) vorgesehen ist.

**Claims**

1. A method for the non-volatile storage of the count of an electronic counting circuit, wherein the respective count is stored by electrically re-programming a non-volatile data store (15), characterised in that the new items of count data are in each case input into a different address zone of the data store (15) before the old items of count data are erased, and that between the individual steps necessary to re-programme the data store (15), storage cells of a non-volatile control store (16) are written into or erased, where items of control information to terminate an interrupted re-programming procedure can be derived from the logic states of said storage cells.

2. A method as claimed in claim 1, characterised in that the items of control information which terminate an interrupted re-programming procedure are obtained by logic or arithmetic linking of the data items stored in the data store (15).

3. A method as claimed in claim 1 or 2, characterised in that the re-programming procedure is carried out only on the occasion of every n-th change of the count.

4. An arrangement for carrying out the method claimed in one of the claims 1 to 3, characterised in that a counting circuit (10) is provided which is connected via a flow control unit (13) to at least one electrically re-programmable, non-volatile data store (15) and that a non-volatile control store (16) is provided which is connected to the flow control unit (13) and whose storage cells (Flag 1, Flag 2, Flag 3, Flag 4) are written into or erased in dependence upon individual steps necessary to re-programme the data store (15).

5. An arrangement as claimed in claim 4, characterised in that the data store (15) has at least two address zones (a, b) into which items of count data can be alternately entered.

6. An arrangement as claimed in claim 4 or claim 5, characterised in that a first storage cell (Flag 1) of the control store (16) is provided, from whose logic state it is possible to determine that address zone (a, b) of the data store (15) in which the valid count is stored.

7. An arrangement as claimed in one of the claims 4 to 6, characterised in that a second storage cell (Flag 2) of the control store (16) is provided, from whose logic state it is possible to determine whether a write procedure relating to the first address zone (a) of the data store (15) has been interrupted.

8. An arrangement as claimed in one of the claims 4 to 7, characterised in that at least one further storage cell (Flag 3) of the control store (16) is provided, from whose logic state it is possible to determine whether a write procedure relating to another address zone (b) of the data store (15) has been interrupted.

6

**0 067 364**

9. An arrangement as claimed in one of the claims 4 to 8, characterised in that an erasing storage cell (Flag 4) of the control store (16) is provided, from whose logic state it is possible to determine whether the erasing procedure has been interrupted following the completion of the write procedure.

10. An arrangement as claimed in one of the claims 4 to 9, characterised in that an electrically re-programmable, non-volatile store is provided, the storage cells of which are divided into zones for the data store (15) and zones for the control store (16).

11. An arrangement as claimed in one of the claims 4 to 10, characterised in that a sensor circuit (14) is provided which supplies an interruption signal to the flow control unit (13) in the event of an interruption in the supply voltage.

## Revendications

1. Procédé pour réaliser la mémorisation rémanente de l'état de comptage d'un circuit de comptage électronique, selon lequel on mémorise l'état de comptage respectif au moyen d'une reprogrammation électrique d'une mémoire rémanente de données (15), caractérisé par le fait qu'on enregistre les nouvelles données respectives de l'état de comptage, avant l'effacement des anciennes données de l'état de comptage, dans une autre zone d'adresse de la mémoire de données (15) et qu'entre les pas individuels nécessaires pour la reprogrammation de la mémoire de données (15), on exécute un enregistrement ou un effacement dans des cellules d'une mémoire rémanente de commande (16), à partir des états logiques de laquelle on peut dériver des informations de commande pour achever un processus interrompu de reprogrammation.

2. Procédé suivant la revendication 1, caractérisé par le fait que les informations de commande pour l'achèvement d'un processus interrompu de reprogrammation sont obtenues au moyen d'une combinaison logique ou arithmétique des données mémorisées dans la mémoire de données (15).

3. Procédé suivant la revendication 1 ou 2, caractérisé par le fait que le processus de reprogrammation n'est exécuté que lors de chaque n-ème modification de l'état de comptage.

4. Dispositif pour la mise en œuvre du procédé suivant l'une des revendications 1 à 3, caractérisé par le fait qu'il est prévu un circuit de comptage (10), qui est relié par l'intermédiaire d'un dispositif de commande d'exécution (3) à au moins une mémoire rémanente de données (15) reprogrammable électriquement, et qu'il est prévu une mémoire rémanente de commande (16) qui est reliée au dispositif de commande d'exécution (13) et dans les cellules (Flag 1, Flag 2, Flag 3, Flag 4) de laquelle on réalise un enregistrement ou un effacement en fonction de pas individuels nécessaires pour la reprogrammation de la mémoire de données (15).

5. Dispositif suivant la revendication 4, caractérisé par le fait que la mémoire de données (15) comporte au moins deux zones d'adresses (a, b), dans lesquelles des données d'états de comptage peuvent être enregistrées en alternance.

6. Dispositif suivant la revendication 4 ou 5, caractérisé par le fait qu'il est prévu, dans la mémoire de commande (16), une première cellule de mémoire (Flag 1), à partir de l'état logique de laquelle on peut déterminer dans quelle zone d'adresses (a, b) de la mémoire de données (15) se trouve mémorisé l'état valable de comptage.

7. Dispositif suivant l'une des revendications 4 à 6, caractérisé par le fait qu'il est prévu, dans la mémoire de commande (16), une seconde cellule de mémoire (Flag 2), à partir de l'état logique de laquelle on peut déterminer si un processus d'enregistrement concernant la première zone d'adresse (a) de la mémoire de données (15) a été interrompu.

8. Dispositif suivant l'une des revendications 4 à 7, caractérisé par le fait qu'il est prévu, dans la mémoire de commande (16), au moins une autre cellule de mémoire (Flag 3), à partir de l'état logique de laquelle on peut déterminer si un processus d'enregistrement concernant une autre zone d'adresse (b) de la mémoire de données (15) a été interrompu.

9. Dispositif suivant l'une des revendications 4 à 8, caractérisé par le fait qu'il est prévu, dans la mémoire de commande (16), une cellule de mémoire d'effacement (Flag 4), à partir de l'état logique de laquelle on peut déterminer si le processus d'effacement a été interrompu après l'exécution d'un processus d'enregistrement.

10. Dispositif suivant l'une des revendications 4 à 9, caractérisé par le fait qu'il est prévu une mémoire rémanente reprogrammable électriquement, dont les cellules sont subdivisées en zones pour la mémoire de données (15) et en zones pour la mémoire de commande (16).

11. Dispositif suivant l'une des revendications 4 à 10, caractérisé par le fait qu'il est prévu un circuit de détection (14) qui, dans le cas d'une défaillance de la tension d'alimentation, délivre un signal d'interruption au dispositif de commande d'exécution (13).